# EUROPEAN PATENT APPLICATION

(11) **EP 0 559 468 A2**
(43) Date of publication of application: **08.09.1993**
(21) Application number: 93301652.9
(22) Date of filing: 04.03.1993
(51) Int. Cl.: G11B 27/10, G11B 20/12, G11B 7/00, G11B 20/18, G11B 7/007

(54) **Information recording method and apparatus**

(30) Priority: 06.03.1992 JP 83055/92
(71) Applicant: CANON KABUSHIKI KAISHA, Tokyo (JP)
(72) Inventor: Tamegai, Masahiro, c/o Canon Kabushiki Kaisha, Kawasaki-shi, Kanagawa-ken (JP)
(74) Representative: Beresford, Keith Denis Lewis

(57) **Abstract**

An information recording is performed as follows. Data is recorded in a recording carrier such as an optical card or the like. The recorded data is verified to perform an error detection. Information regarding detected errors is recorded in a first directory on the recording carrier. When all of the information regarding errors can not be recorded in the first directory on the recording carrier, the remaining information regarding errors other than the information recorded in the first directory is recorded in a second directory on the recording carrier.

## Description

### BACKGROUND OF THE INVENTION

### Field of the Invention

The present invention relates to a method and apparatus for recording information in an information recording carrier and, more particularly, to a method and apparatus for recording information in a so-called WORM-type recording carrier.

### Related Background Art

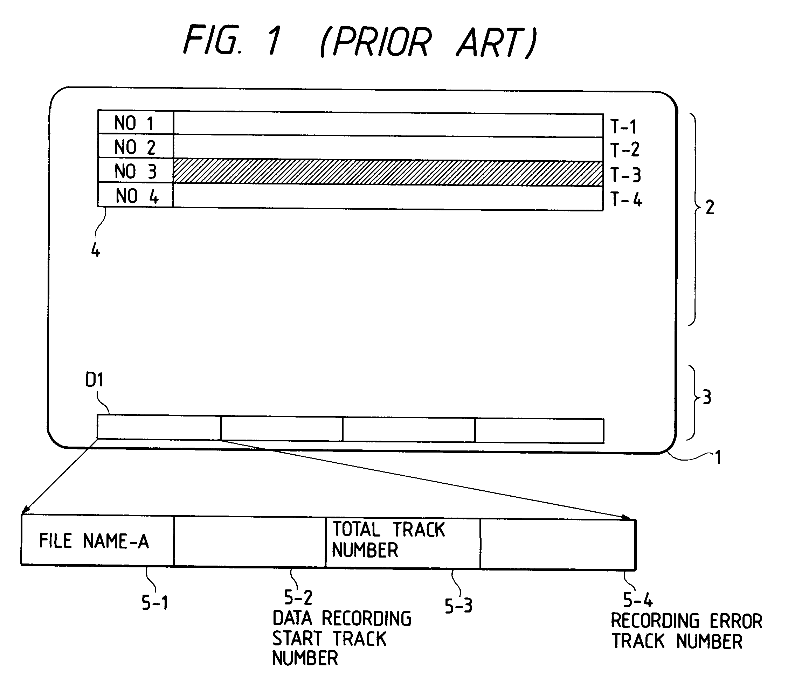

Conventionally, an optical disk or an optical card which optically records information is known as an information recording carrier. In recording or reproducing data with respect to such a recording carrier, it is common practice to manage the data in units of files. To manage this file data, a so-called directory is used. Directory information is normally file information, such as a file name, a file length, and a heading track, and is written in a portion of the recording carrier. If a defect occurs in a portion of the recording carrier to form an area in which recording/reproduction of information is impossible, alternating processing is performed to relieve the information; that is, the same information is recorded again in an area (to be referred to as an alternate area hereinafter) as an alternative to the defective area. A method of this alternating processing is proposed in Japanese Laid-Open Patent Application No. 61-243994. This method of alternating processing will be described below with reference to Fig. 1. Referring to Fig. 1, an optical card 1 is illustrated as an information recording carrier. A recording area of the optical card 1 is divided into a data recording area 2 and a directory area 3, and representative tracks T1 to T4 are illustrated in the data recording area 2. Assume that a series of information of three tracks are to be recorded as a single file and the file name is A. A directory D1 in the directory area 3 is directory information for managing file data recorded in the tracks T1 to T4. The directory D1 consists of a file name 5-1, a data recording start track number 5-2, a total track number 5-3, and a recording error track number 5-4. Note that reference numeral 4 denotes track numbers.

To record information of the file A in this optical card 1, the information is first recorded in the first track T1, and, immediately after the recording, the recorded information on the track T1 is read out to perform verification. If the result of verification indicates that the information is correctly recorded, the remaining information is recorded in the next track T2 and so on. In the same fashion, a series of file data are recorded in the tracks T3 and T4. If, however, a verification error occurs in the track T3, for example, the track number at which the error occurred is recorded in a memory, and the number stored in a track number memory in which the number of tracks of data is stored is rewritten from three tracks to four tracks. Subsequently, the data to be recorded in the track T3 is rerecorded in the track T4. If no error is detected as a result of verification, it is determined that all data of the file A are completely recorded, and the directory information described above, such as the file name A and the data recording start track number, is recorded in the directory D1. Verification of the directory information is of course performed immediately after the information is recorded in the directory D1. In reproduction of the data, the directory information is read out before readout of the data. If a track with an error exists, this track is skipped, and data at a track as an alternative to that track is read out.

In the above conventional information recording method, however, if a large number of tracks in which recording errors occurred are present in a single file, it is sometimes impossible to record all the error track numbers in one directory. This interferes with management of file data.

### SUMMARY OF THE INVENTION

It is an object of the present invention to solve the above problems of the prior arts and provide an information recording method and apparatus in which even if a large number of errors are present in recorded data, all information related to the errors can be recorded in directories, thereby reliably performing data management.

In order to achieve the above object, an information recording method according to one aspect of the present invention comprises the steps of:
recording data in a recording carrier;
verifying the recorded data to perform error detection;
recording information related to detected errors in a first directory on the recording carrier; and
if not all of the information related to errors can be recorded in the first directory, recording the remaining information, except the information recorded in the first directory, in a second directory on the recording carrier.

In order to achieve the above object, an information recording method according to another aspect of the present invention comprises the steps of:
recording data in a recording carrier;
verifying the recorded data to perform error detection;
if all of information related to detected errors can be recorded in a first directory on the recording carrier, recording all the information related to errors in the first directory; and
if not all of the information related to errors can be recorded in the first directory, recording all the information related to errors not in the first directory but in a second directory on the recording carrier.

In order to achieve the above object of the present invention, an information recording apparatus comprises:
data recording means for recording data in a recording carrier;
error detecting means for verifying the recorded data to perform error detection; and
error information recording means for recording information related to detected errors in the recording carrier, the error information recording means recording the information related to errors in a first directory on the recording carrier, and, if not all of the information related to errors can be recorded in the first directory, recording the remaining information, except the information recorded in the first directory, in a second directory on the recording carrier.

### BRIEF DESCRIPTION OF THE DRAWINGS

Fig. 1 is a schematic plan view of an optical card, for explaining a conventional recording method;
Fig. 2 is a schematic view showing an embodiment of an information recording apparatus according to the present invention;
Fig. 3 is a schematic plan view of an optical card, for explaining a recording method of the present invention;
Figs. 4A and 4B are views showing the formats of directories recorded by the method of the present invention;
Fig. 5 is a flow chart for explaining the data recording method according to the present invention;
Fig. 6 is a flow chart for explaining an embodiment of an error information recording method according to the present invention;
Figs. 7A to 7C are views showing the formats of directories recorded by the method shown in Fig. 6;
Fig. 8 is a flow chart for explaining another embodiment of the error information recording method according to the present invention; and
Figs. 9A to 9C are views showing the formats of directories recorded by the method shown in Fig. 8.

### DETAILED DESCRIPTION OF THE PREFERRED EMBODIMENTS

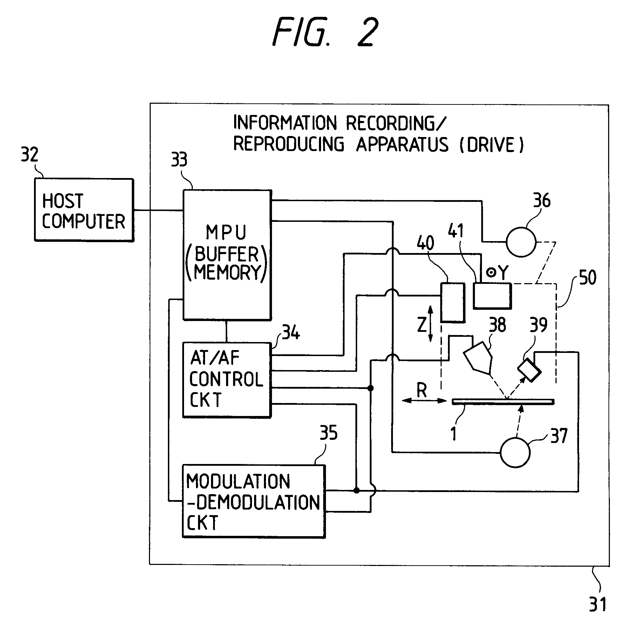

The embodiments of the present invention will be described in detail below with reference to the accompanying drawings. Fig. 2 is a schematic view showing an embodiment of an information recording/reproducing apparatus according to the present invention. Referring to Fig. 2, this information recording/reproducing apparatus (to be referred to as a drive hereinafter) 31 performs recording and reproducing of information using a WORM-type optical card 1 as an information recording carrier. The drive 31 is connected to a host computer 32 as an upper control unit and performs recording and reproduction of information on the basis of an instruction from the host computer 32. Reference numeral 37 denotes a motor by which an optical card 1 is introduced into the drive to be reciprocally moved in a direction R in a predetermined drive and is ejected from the apparatus in association with a conveying mechanism (not shown). A light beam radiating optical system 38 including a light source forms a light beam spot on the optical card 1 in recording and reproduction of information. A photodetector 39 receives reflected light of the light beam spot formed on the optical card 1. An AF actuator 40 drives a part of the light beam radiating optical system 38 to move the focusing position of the light beam spot on the surface of the optical card 1 in a direction Z, i.e., a direction perpendicular to the surface of the optical card, thereby performing auto-focusing (AF). An AT actuator 41 drives a part of the light beam radiating optical system 38 to move the light beam spot on the surface of the optical card in a direction Y (i.e., a direction perpendicular to both the directions R and Z), thereby performing auto-tracking (AT). An optical head 50 is integrally constituted from the light beam radiating optical system 38, the photodetector 39, the AF actuator 40, and the AT actuator 41. A drive motor 36 moves this optical head 50 in the direction Y to allow the light beam spot to access a desired track on the optical card 1.

A microprocessing unit (MPU) 33 incorporates a read-only memory (ROM) and a random access memory (RAM). The MPU 33 controls the card feed motor 37 and the head feed motor 36 and also controls communications of data with respect to the host computer 32 under the control of the host computer 32. An AT/AF control circuit 34 receives signals from the photodetector 39 to drive the AF actuator 40 and the AT actuator 41, controlling focusing and tracking. That is, upon receiving the output from the photodetector 39, the AT/AF control circuit 34 controls the AF actuator 40 and the AT actuator 41 on the basis of the received output, thereby controlling AF and AT. The output from the photodetector 39 is also output to a modulation-demodulation circuit 35 to perform demodulation of readout information, and the consequent demodulated signal is sent to the MPU 33. The modulation-demodulation circuit 35 modulates an information signal from the MPU 33 and drives the light beam radiating optical system 38 to execute information recording in accordance with the modulated signal. In reproduction of data, the modulation-demodulation circuit 35 demodulates the data on the basis of the signal from the photodetector 39. The host computer 32 exchanges data with respect to the drive 31 and instructs the drive 31 to perform recording and reproduction of information in units of data tracks in and from the optical card 1. Note that the optical card 1 generally has a high error rate due to the properties of this medium, and so an error correcting means is necessary in situations where highly reliable information is required.

A recording procedure in the apparatus shown in Fig. 2 will be described below. First, when data is sent from the host computer 32, the MPU 33 stores the data in its internal buffer memory. The MPU 33 then sends a command to the card feed motor 37 to linearly move the optical card 1 forward and backward. Subsequently, the MPU transfers the data to the modulation-demodulation circuit 35 and causes the optical system 38 to radiate a light beam, which is modulated in accordance with the data, onto the optical card 1, thereby recording the data.

Thereafter, the MPU 33 causes the optical system 38 to radiate a light beam with a predetermined power lower than that in recording onto an area of the optical card 1 where the data is recorded. The photodetector 39 detects reflected light of the light beam from the optical card 1. The output from the photodetector 39 is sent to the modulation-demodulation circuit 35 to reproduce the data. The reproduced data is supplied to the MPU 33. The MPU 33 performs error detection by comparing the reproduced data with the data stored in the buffer memory. The MPU 33 then forms an error list on the basis of errors detected. This error list is constituted by the first sector address of a block, that consists of at least one continuous sector in which an error is detected; and the number of sectors included in that block.

Information of the error list formed as described above is supplied from the MPU 33 to the modulation-demodulation circuit 35. The optical system 38 radiates a light beam, which is modulated in accordance with the error list information, onto a directory area of the optical card 1, thus recording the error list information. In the case of an optical card, the directory area is set, for example, on the side opposite to the side of the data area on the recording surface of the optical card. In this case, data are recorded in sequence from one end of the optical card, and the error list information is recorded in sequence from the other end of the optical card.

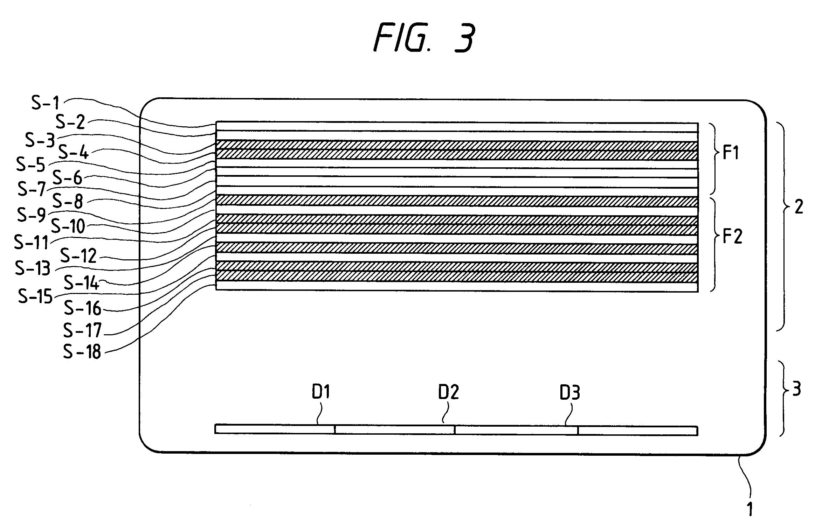

An embodiment of an information recording method according to the present invention will be described next. Fig. 3 is a view showing the recording surface of an optical card for use in the information recording method of this embodiment. Referring to Fig. 3, this optical card 1 has a data area 2 and a directory area 3. Among sectors S-1 to S-8, those represented as hatched portions are sectors in which errors are detected in verification after recording. The optical card 1 also includes files F1 and F2, each constituted by a plurality of sectors, and directories D1 to D3. Note that addresses representing sector positions in the data area divided into a plurality of sectors will be called physical addresses hereinafter for convenience. In Fig. 3, the sectors S-1, S-2, and S-3 have physical addresses 1, 2, and 3, respectively. On the other hand, sectors in which it is confirmed, as a result of verification after recording, that the recording has been correctly performed will be called logical addresses hereinafter for convenience. Assume that these logical addresses are numbered in sequence from the first one. In Fig. 3, therefore, logical addresses are determined such that the sector S-1 has a logical address 1, the sector S-2 has a logical address 2, the sector S-5 has a logical address 3, and so forth.

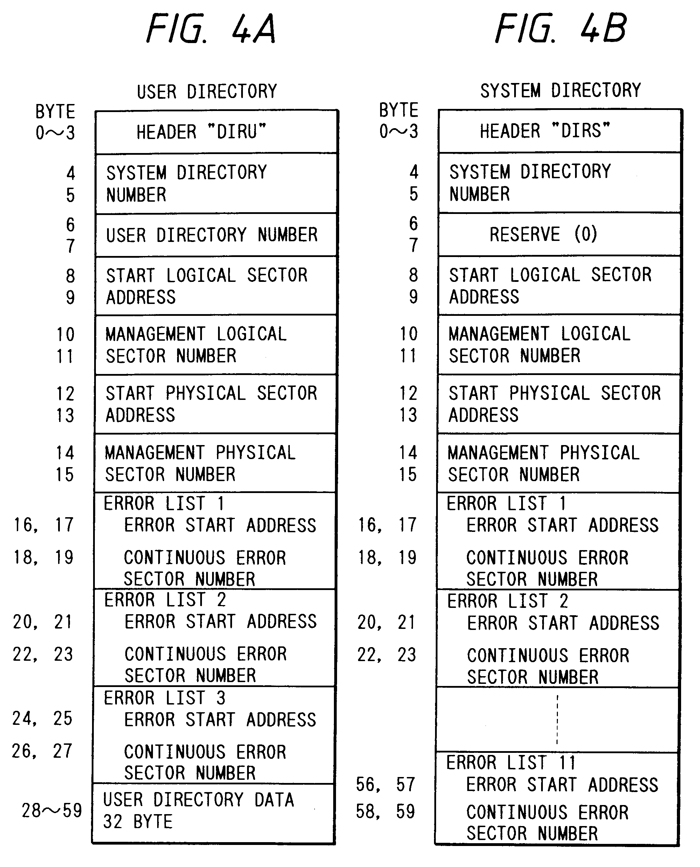

Figs. 4A and 4B show the formats of a user directory and a system directory, respectively, of this embodiment. These directory formats will be described below. A header is for distinguishing between the user directory and the system directory, in which "DIRU" or "DIRS" is written by the ASCII code. A system directory number is a serial number that is common to the system directory and the user directory. A user directory number is a serial number applied only to the user directory. A start logical sector address and a management logical sector number indicate the first logical address of a logical area that the directory manages and the size of that area. A start physical sector address and a management physical sector number indicate the first physical address of a physical area that the directory manages and the size of that area. An error list represents error information constituted by an error start address, which is the first physical address of a sector in which an error is detected, and a continuous error sector number. This recording method is very effective against an burst error because the method requires only a small number of bytes. It is possible to record three error lists 1, 2, and 3 in the user directory, and eleven error lists 1 to 11 in the system directory. User directory data is recorded only in the user directory and consists of information, such as a file name and a file size.

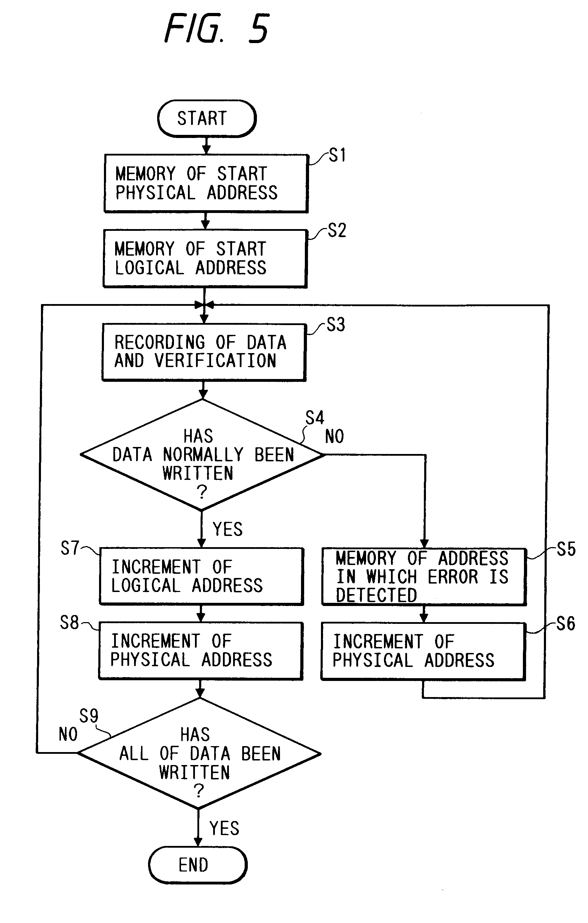

Fig. 5 is a flow chart showing the flow of file data recording processing in the information recording method of this embodiment. In this embodiment, assume that the data of the file F2 (Fig. 3) having the volume of four sectors is to be recorded as an example. Referring to Fig. 5, the host computer 32 issues a recording request to the drive 31 and transmits the data of the file F2. This data is received by the MPU 33 of the drive 31. Prior to recording of the data, the MPU 33 stores a physical address and a logical address, at which recording is to be started, in its internal memory (steps S1 and S2). In this embodiment, as is apparent from Fig. 3, the physical address is the address 9, and the logical address is the address 7. Subsequently, the MPU 33 controls each individual section to record the data in the sector at the physical address 9 (S-9) of interest and immediately performs verification by reproducing the data recorded (step S3). After the verification, the MPU 33 checks whether the data has correctly been written (step S4). In this case, since the physical address 9 is a defective sector as shown in Fig. 3, a verification error is naturally detected. When the verification error is detected, therefore, the MPU stores the address of the sector, in which the error is detected, in the memory (step S5) and increments the target physical address by one (step S6), and the flow returns to step S3. In step S3, the MPU 33 rerecords the data at the address 10, as the next physical address, and performs verification of that data. In this case, since the physical address 10 is a normal sector as shown in Fig. 3, no verification error is detected. Therefore, the MPU 33 allocates the logical address to the sector in which the data is normally written, increments the logical address by one for the next data recording (step S7), and also increments the physical address by one for the next data recording (step S8). The MPU 33 then checks whether all of the data of the file F2 requested has been written (step S9). If NO in step S9, the flow returns to step S3, and the MPU 33 repeats the above processing. If the MPU 33 determines that all of the data of the file F2 has been recorded, the MPU 33 informs the host computer 32 of the completion of recording, thereby finishing the recording processing.

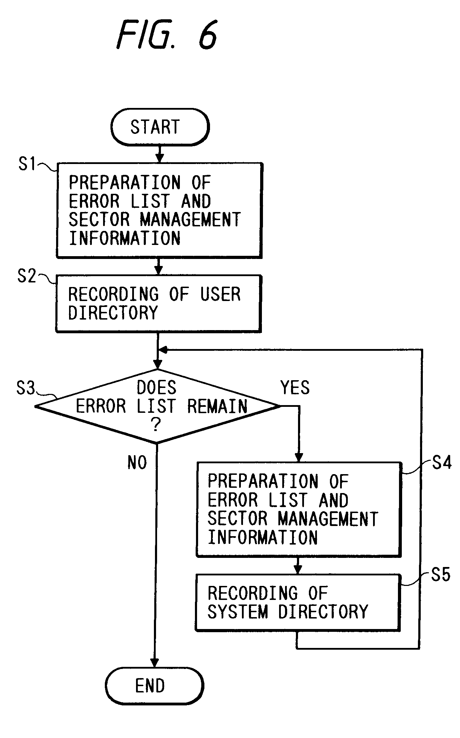

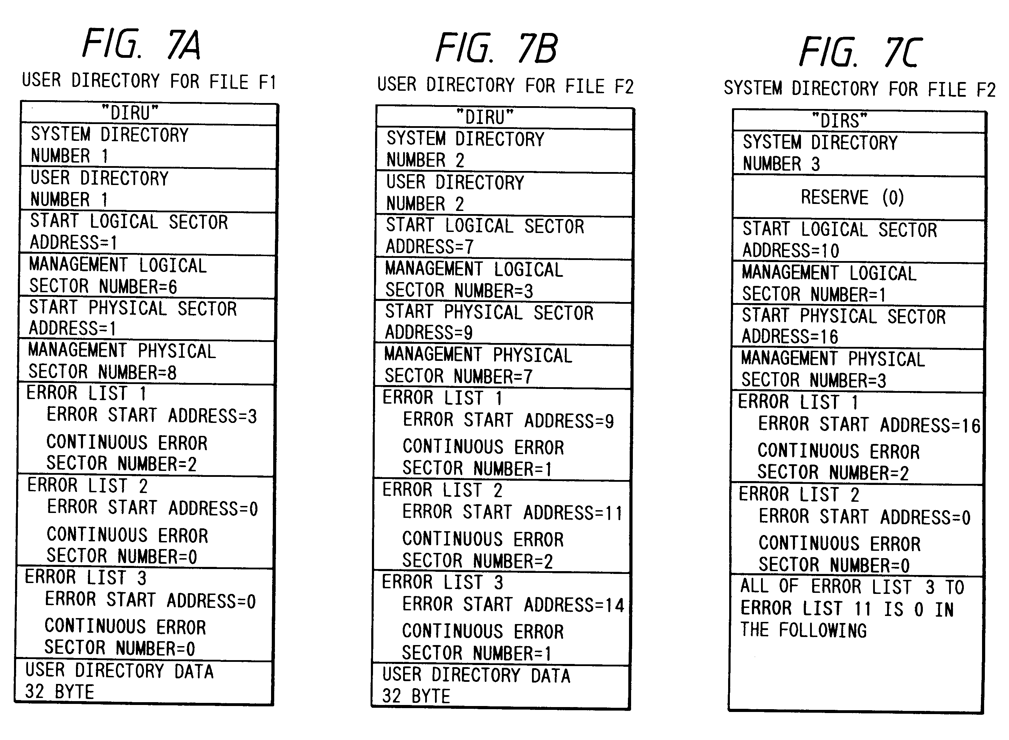

Fig. 6 is a flow chart showing the flow of a directory recording method according to this embodiment. This directory recording shown in Fig. 6 is executed after all of the data of the file F2 is recorded in accordance with the flow chart of Fig. 5. Figs. 7A to 7C are views showing the contents of directories when the directory recording is performed in accordance with Fig. 6. The directory recording method will be described below with reference to Figs. 6, 2, 3, and 7A to 7C. First, in Fig. 6, the MPU 33 prepares an error list and sector management information on the basis of the sector address (error sector address) of a sector in which an error is detected, the start recording physical address, the end recording physical address, the start recording logical address, and the end recording logical address, that are stored in the memory (step S1). The information such as the error sector address stored in the memory is information that is stored during recording of information, as described above with reference to Fig. 5. The error list is prepared before recording of the user directory, and a maximum of three error lists can be formed. Fig. 7B shows the error lists and the sector management information prepared. In Fig. 7B, the start logical sector address is 7, and the start physical sector address is 9. In addition, the error start address of the error list 1 is 9, and its continuous error sector number is 1; the error start address of the error list 2 is 11, and its continuous error sector number is 2; and the error start address of the error list 3 is 14, and its continuous error sector number is 1. Note that in this embodiment, since the maximum number of error lists that can be recorded in the user directory is three, an error list for the error start address 16 shown in Fig. 3 is not formed.

In this manner, the MPU 33 records the user directory consisting of the error lists and the sector management information shown in Fig. 7B in the optical card 1 (step S2). If all of the error information and the sector management information for the file F2 can be recorded in the user directory, the MPU 33 immediately finishes the directory recording processing. That is, the MPU 33 checks whether an error list remains (step S3), and finishes the processing if none remains. In this embodiment, as described above, an unrecorded error list remains, and so the MPU 33 prepares this unrecorded error list and sector management information (step S4) and records the system directory on the basis of these list and information (step S5). The MPU 33 repeatedly executes the processing from steps S3 to S5 until the error information in the file F2 is completely processed, and finishes the processing when all the information is recorded. Fig. 7C shows the system directory thus recorded. As shown in Fig. 7C, the error list related to the error sector address 16 and the sector management information are recorded. Note that since the number of the remaining error sectors is one in this embodiment, only an error list 1 (error start address = 16, continuous error sector number = 1) concerning the error sector is recorded as shown in Fig. 7C. As mentioned earlier, however, a maximum of 11 error lists can be recorded in this system directory. Fig. 7A shows the contents of the system directory when data of the file F1 shown in Fig. 3 is recorded. Since two sectors in which errors are detected are present in the file F1 and these two sectors are continuous, only an error list 1 (error start address = 3, continuous error sector number = 2) is recorded as shown in Fig. 7A. Therefore, for the number of error lists is three or less, a user directory alone is recorded without recording a system directory.

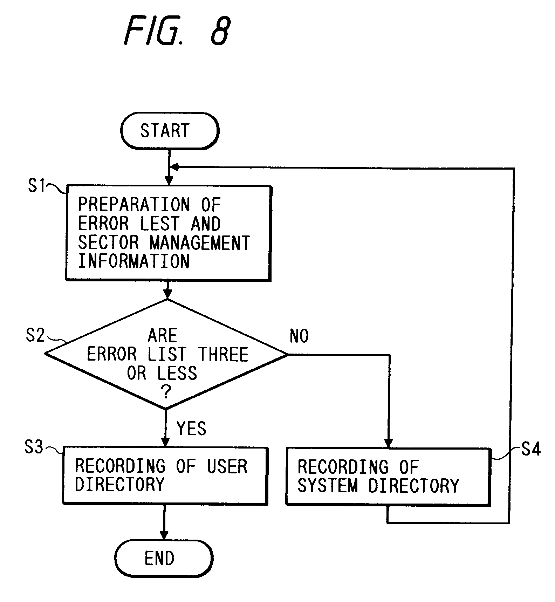

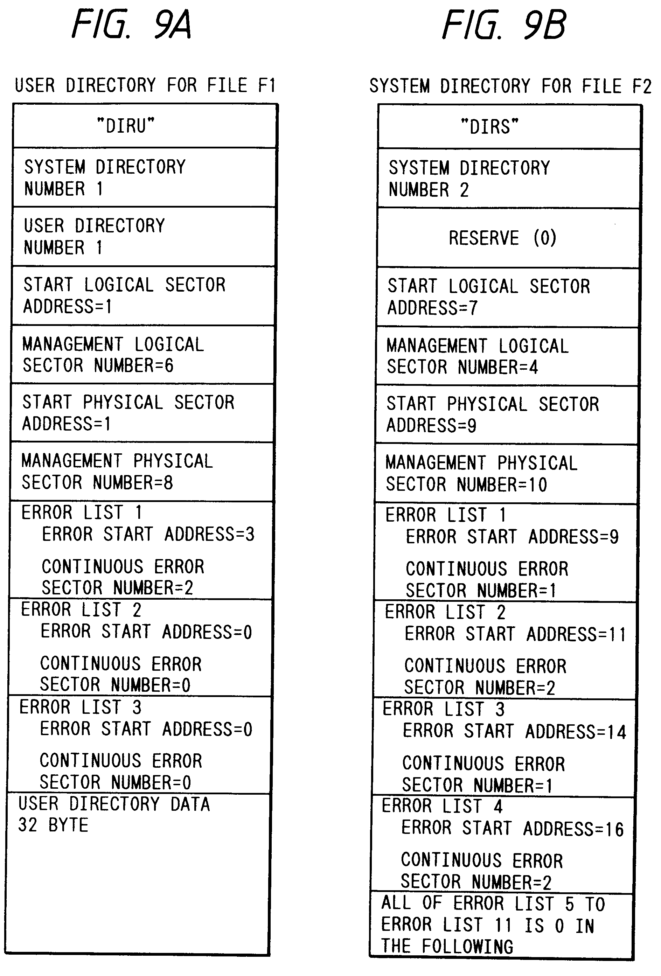

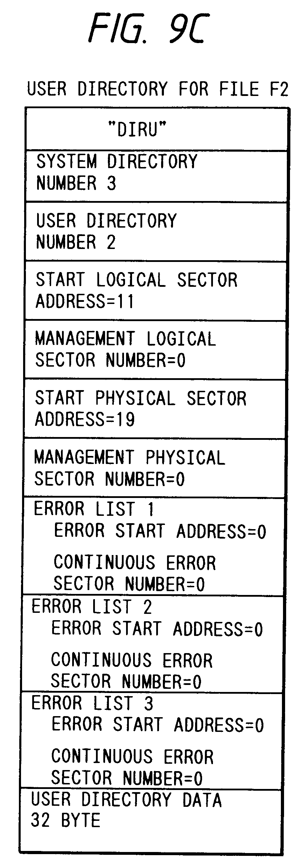

A directory recording method according to another embodiment of the present invention will be described below. Fig. 8 is a flow chart showing the directory recording method according to this embodiment, and Figs. 9A to 9C are views showing the contents of directories recorded in accordance with the flow chart of Fig. 8. Note that the directory recording method of this embodiment will be described by taking recording of the file F2 shown in Fig. 3 as an example, as in the above embodiment. Referring to Fig. 8, the MPU 33 first prepares an error list and sector management information from the error information, the start recording physical address, the end recording physical address, the start recording logical address, and the end recording logical address that are stored in the memory (step S1). In this case, a maximum number of error lists is 11. The MPU 33 checks whether the error lists prepared are three or less (step S2). If the error lists are three or less, the MPU 33 records only a user directory and finishes the processing. In this embodiment, however, error sectors corresponding to four error lists are present in the file F2. Therefore, no error list is recorded in the user directory as shown in Fig. 9C, and the flow advances to step S4 to perform recording of a system directory. Fig. 9B shows the contents of the system directory recorded. As shown in Fig. 9B, error lists 1 to 4 are recorded on the basis of the error sector information in the file F2. Note that the contents of Fig. 9B are exactly the same as those shown in Figs. 7B and 7C of the above embodiment although the recording methods are different. In recording of the file F1, the contents of the directory are as shown in Fig. 9A. In this case, since an error list to be recorded is one in the file F1, the user directory is recorded in step S3 of Fig. 8. The contents of the user directory shown in Fig. 9A are exactly the same as those of the user directory shown in Fig. 7A. In this embodiment, the processing amount in the MPU 33 is smaller than that in the embodiment of Fig. 6, and so the load on the MPU 33 can be reduced.

According to the present invention, as has been described above, if not all of information of file data can be recorded in the first directory, the remaining information is written in the second directory. Therefore, since all the information of the file data can be recorded, management of the file data can be performed reliably.

The present invention can be used in a variety of applications in addition to the above embodiment. As an example, although the above embodiment is an optical information recording apparatus for recording information by using a light beam, the present invention is applicable to apparatuses that record information using some other means, e.g., a magnetic recording apparatus for recording information through a magnetic head. In addition, the present invention can be applied to apparatuses using not only optical cards but recording carriers of any form, such as disk-like or tape-like recording carriers: The present invention incorporates all these applications without departing from the scope of claims.

## Claims

1. An information recording method comprising the steps of:
recording data in a recording carrier;
verifying the recorded data to perform error detection;
recording information related to detected errors in a first directory on said recording carrier; and
if not all of the information related to errors can be recorded in said first directory, recording the remaining information, except the information recorded in said first directory, in a second directory on said recording carrier.

2. A method according to claim 1, further comprising the step of recording identification information in each of said first and second directories to distinguish between said first and second directories.

3. A method according to claim 1, wherein said recording carrier has a plurality of sectors for recording data, each of which is given a sector address, and the information related to errors consists of a sector address of a first sector in a block constituted by at least one continuous sector, in which the errors are detected, and the number of sectors contained in the block.

4. A method according to claim 1, further comprising the step of recording a file name and a file size of data in said first directory.

5. A method according to claim 1, wherein said recording carrier comprises an optical card, data are recorded in sequence from one end portion of said optical card, and the information related to errors is recorded in sequence from the other end portion of said optical card.

6. A method according to claim 1, wherein the step of verifying the recorded data to perform error detection comprises the steps of storing data in a buffer memory before the data is recorded in said recording carrier, reading out the recorded data from said recording carrier, and comparing the readout data with the data stored in said buffer memory.

7. An information recording method comprising the steps of:
recording data in a recording carrier;
verifying the recorded data to perform error detection;
if all of information related to detected errors can be recorded in a first directory on said recording carrier, recording all the information related to errors in said first directory; and
if not all of the information related to errors can be recorded in said first directory, recording all the information related to errors not in said first directory but in a second directory on said recording carrier.

8. A method according to claim 7, further comprising the step of recording identification information in each of said first and second directories to distinguish between said first and second directories.

9. A method according to claim 7, wherein said recording carrier has a plurality of sectors for recording data, each of which is given a sector address, and the information related to errors consists of a sector address of a first sector in a block constituted by at least one continuous sector, in which the errors are detected, and the number of sectors contained in the block.

10. A method according to claim 7, further comprising the step of recording a file name and a file size of data in said first directory.

11. A method according to claim 7, wherein said recording carrier comprises an optical card, data are recorded in sequence from one end portion of said optical card, and the information related to errors is recorded in sequence from the other end portion of said optical card.

12. A method according to claim 7, wherein the step of verifying the recorded data to perform error detection comprises the steps of storing data in a buffer memory before the data is recorded in said recording carrier, reading out the recorded data from said recording carrier, and comparing the readout data with the data stored in said buffer memory.

13. An information recording apparatus comprising:
data recording means for recording data in a recording carrier;
error detecting means for verifying the recorded data to perform error detection; and
error information recording means for recording information related to detected errors in said recording carrier, said error information recording means recording the information related to errors in a first directory on said recording carrier, and, if not all of the information related to errors can be recorded in said first directory, recording at least a portion of the information related to errors in a second directory on said recording carrier.

14. An apparatus according to claim 13, wherein if not all of the information related to errors can be recorded in said first directory, said error information recording means records some of the information related to errors in said first directory and the remaining some of the information in said second directory on said recording carrier.

15. An apparatus according to claim 13, wherein if not all of the information related to errors can be recorded in said first directory, said error information recording means records all the information related to errors not in said first directory but in said second directory on said recording carrier.

16. An apparatus according to claim 13, wherein said error information recording means records identification information in each of said first and second directories to distinguish between said first and second directories.

17. An apparatus according to claim 13, wherein said recording carrier has a plurality of sectors for recording data, each of which is given a sector address, and the information related to errors consists of a sector address of a first sector in a block constituted by at least one continuous sector, in which the errors are detected, and the number of sectors contained in the block.

18. An apparatus according to claim 13, wherein said error information recording means records a file name and a file size of data in said first directory.

19. An apparatus according to claim 13, wherein said recording carrier comprises an optical card, and said data recording means records data in sequence from one end portion of said optical card, and said error information recording means records the information related to errors in sequence from the other end portion of said optical card.

20. An apparatus according to claim 13, wherein said data recording means and said error information recording means comprise an optical system for radiating a light beam, which is modulated in accordance with the data and the information related to errors, onto said recording carrier.

21. An apparatus according to claim 13, wherein said error detecting means comprises a buffer memory for storing data before the data is recorded in said recording carrier, an optical system for radiating a light beam with a predetermined power onto a portion of said recording carrier in which data is recorded, a photodetector for detecting reflected light of the light beam from said recording carrier, a reproducing circuit for reproducing data in accordance with an output from said photodetector, and a processing circuit for comparing the data reproduced by said reproducing circuit with the data stored in said buffer memory.

22. An information recording apparatus including: means for recording data on a data carrier; means for detecting errors in the recorded data; and means for producing a record of all the detected errors on the data carrier.

23. An information recording method including the steps of: recording data on a data carrier; detecting errors in the recorded data; and producing a record of all the detected errors on the data carrier.
